# DEMANDE DE BREVET EUROPEEN

(11) **EP 3 840 033 A1**
(43) Date de publication de la demande: **23.06.2021**
(21) Numéro de dépôt: 20214522.3
(22) Date de dépôt: 16.12.2020
(51) Int. Cl.: H01L 21/762, H01L 21/265, H01L 21/304, H01L 21/322

(54) **PROCÉDÉ DE FABRICATION D'UN SUBSTRAT RF-SOI À COUCHE DE PIÉGEAGE ISSUE D'UNE TRANSFORMATION CRISTALLINE D'UNE COUCHE ENTERRÉE**

(30) Priorité: 17.12.2019 FR 1914563; 19.12.2019 FR 1915019
(71) Demandeur: Commissariat à l'énergie atomique et aux énergies alternatives, 75015 Paris (FR)
(72) Inventeur: REBOH, Shay, 38054 GRENOBLE CEDEX 09 (FR); ACOSTA ALBA, Pablo, 38054 GRENOBLE CEDEX 09 (FR); AUGENDRE, Emmanuel, 38054 GRENOBLE CEDEX 09 (FR)
(74) Mandataire: Brevalex

(57) **Abrégé**

L'invention porte sur un procédé de fabrication d'un substrat de type semi-conducteur sur isolant pour applications radiofréquences, comprenant les étapes de
collage direct d'un substrat support (1) en un matériau monocristallin et d'un substrat donneur (5) comportant une couche mince (7) d'un matériau semi-conducteur, une ou plusieurs couches de matériau diélectrique (2) étant à l'interface ; et de
report de ladite couche mince (7) sur le substrat support.

Le procédé comprend une étape de formation d'une région de piégeage de charges électriques dans le substrat support par transformation d'une zone enterrée du substrat support en un polycristal.

## Description

### DOMAINE TECHNIQUE

Le domaine de l'invention est celui des substrats de type semi-conducteur sur isolant pour applications radiofréquences. L'invention concerne plus particulièrement un procédé de fabrication d'une structure de type silicium sur isolant comprenant une couche de piégeage de charges électriques.

### TECHNIQUE ANTÉRIEURE

Dans les systèmes cellulaires et Wi-Fi, le module RF (« Front End Module ») est l'un des composants les plus critiques. Agissant comme une interface entre l'antenne et l'émetteur-récepteur RF, le module RF comprend des composants sensibles tels qu'un amplificateur d'antenne LNA (« Low Noise Amplifier »), des amplificateurs de puissance, des commutateurs d'accord d'antenne et une unité de gestion de l'alimentation.

Pour relever des défis de conception tels que l'isolement des commutateurs linéaires et l'optimisation de l'efficacité des amplificateurs de puissance, l'industrie a mis au point des processus spécifiques pour chaque composant du module RF, conduisant ainsi la création de multiples composants et circuits intégrés.

Alors que les nouvelles normes à haute vitesse, comme la téléphonie mobile 4G et 5G, utilisent jusqu'à 40 bandes de fréquences différentes pour augmenter le débit des données, les nouveaux équipements réseau nécessitent des circuits RF supplémentaires, ce qui en augmente considérablement la taille. Cette complexité accrue nécessite de nouveaux processus à même d'offrir une plus grande flexibilité et une meilleure intégration sans compromettre les performances.

Dans ce contexte, les substrats RF-SOI (Silicium sur isolant Radio Fréquence ou « Radio-Frequency Silicon On Insulator» en anglais) permettent un niveau d'intégration élevé tout en répondant parfaitement aux exigences RF. Ainsi, parmi les substrats adaptés à l'élaboration de composants RF, on connait par exemple de WO 2005/031842 A2 les substrats à base de silicium haute résistivité comprenant un substrat support, une couche de piégeage de charges électriques (appelée couche « trap rich »), une couche diélectrique disposée sur la couche de piégeage et une couche active de semi-conducteur disposée sur la couche diélectrique.

La fabrication d'un substrat RF-SOI repose aujourd'hui sur une formation de la couche de piégeage de charges électriques par dépôt de silicium polycristallin sur le substrat support et un report de la couche active sur le substrat support selon le procédé Smart Cut™.

Une difficulté est qu'en ayant recours à un dépôt de silicium polycristallin (ou à un dépôt de silicium polycristallin suivi d'un dépôt d'oxyde ou encore à un dépôt de silicium polycristallin suivi d'une oxydation du silicium polycristallin), une rectification de surface s'avère nécessaire afin d'atteindre un niveau de rugosité compatible avec le collage de substrats. Cette rectification, généralement réalisée par polissage mécano-chimique, complexifie la fabrication des substrats RF-SOI et en augmente le coût.

Par ailleurs, lorsque le collage des substrats est réalisé selon une méthode dite inversée, i.e. avec un oxyde présent sur le substrat support collé à une surface silicium du substrat donneur, une difficulté technique tient à l'obtention d'un oxyde thermique (celui-ci étant préféré à un dépôt d'un oxyde du fait de ces meilleures caractéristiques électriques), cette difficulté étant accrue lorsque l'on cherche à disposer d'un oxyde épais. Cette difficulté est liée, d'une part, aux différentes vitesses d'oxydation entre les grains de Si ayant des orientations et des tailles différentes dans le poly-Si et, d'autre part, à l'effet des frontières de grains qui génèrent des variations d'épaisseur et une inhomogénéité de l'oxyde.

### EXPOSÉ DE L'INVENTION

L'invention a pour objectif de proposer un procédé de fabrication d'un substrat RF-SOI qui permette de s'affranchir des inconvénients susmentionnés et d'obtenir en particulier une couche de piégeage prise en sandwich entre un substrat monocristallin et un oxyde thermique à haute qualité de surface pour le collage.

À cet effet, l'invention concerne un procédé de fabrication d'un substrat de type semi-conducteur sur isolant pour applications radiofréquences, comprenant les étapes de
collage direct d'un substrat support en un matériau monocristallin et d'un substrat donneur comportant une couche mince d'un matériau semi-conducteur, une ou plusieurs couches de matériau diélectrique étant à l'interface ; et de report de ladite couche mince sur le substrat support.

Le procédé comprend une étape de formation d'une région de piégeage de charges électriques dans le substrat support en contact avec une couche de matériau diélectrique présente à l'interface par transformation d'une zone enterrée du substrat support en un polycristal.

Certains aspects préférés mais non limitatifs de ce procédé sont les suivants :
- ladite transformation comprend une amorphisation de la zone enterrée du substrat support suivie d'une recristallisation sous forme polycristalline de la zone enterrée ;
- l'amorphisation comprend une implantation ionique ;
- la recristallisation sous forme polycristalline comprend au moins un recuit laser engendrant la création d'une microstructure polycristalline dans la zone enterrée ;
- la recristallisation sous forme polycristalline comprend une pluralité de recuits laser venant successivement recristalliser une épaisseur décroissante de la zone enterrée ;
- la recristallisation sous forme polycristalline comprend après l'au moins un recuit laser une étape de traitement thermique complémentaire ou un recuit laser complémentaire venant promouvoir le développement de la microstructure polycristalline ;
- il comprend, avant l'amorphisation de la zone enterrée du substrat support, la formation d'une couche de matériau diélectrique en surface du substrat support ;
- la formation d'une couche de matériau diélectrique en surface du substrat support est réalisée par oxydation thermique ;
- l'amorphisation de la zone enterrée du substrat support est réalisée dans la zone enterrée du substrat situé directement sous la couche de matériau diélectrique ;
- le substrat donneur est recouvert d'une couche de matériau diélectrique ;
- l'amorphisation de la zone enterrée du substrat support est réalisée après report de ladite couche mince sur le substrat support ;
- l'au moins un recuit laser est réalisé à travers un masque afin de former une zone polycristalline localisée formant la région de piégeage de charges électriques ;
- il comprend, après la réalisation de la région de piégeage de charges électriques et avant le collage du substrat support et du substrat donneur, une étape de retrait d'une couche superficielle du substrat support ;
- il comprend, après la réalisation de la région de piégeage de charges électriques et avant le collage du substrat support et du substrat donneur, une étape d'oxydation d'une couche superficielle du substrat support ;
- l'étape d'oxydation est précédée d'une étape d'épaississement du substrat support ;
- il comprend une étape de formation de pores dans la zone enterrée du substrat support ou une zone directement sous-jacente à ladite zone enterrée dans le substrat support ;
- l'étape de formation de pores dans la zone enterrée du substrat support est réalisée avant la recristallisation de la zone enterrée ;
- l'étape de formation de pores est réalisée de manière localisée ;
- le report comprend une fracture du substrat donneur au niveau d'un plan de fragilisation issu d'une implantation ionique ;
- la zone enterrée du substrat support est une couche pleine plaque.

L'invention porte également sur un substrat de type semi-conducteur sur isolant pour applications radiofréquences, comprenant l'empilement d'un socle en matériau semi-conducteur monocristallin, d'une couche de piégeage de charges électriques en matériau semiconducteur polycristallin, d'une couche diélectrique directement au contact de la couche de piégeage de charges électriques et d'une couche mince en matériau semi-conducteur. L'empilement comprend en outre une couche poreuse entre le socle et la couche de piégeage de charges électriques.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
La figure 1 représente la réflectivité de surface d'une couche de Si amorphe en fonction de la densité d'énergie du faisceau laser utilisé pour la recristallisation en sous forme polycristalline.
La figure 2 illustre un premier mode de réalisation du procédé selon l'invention avec formation d'une couche de piégeage de charges électriques enterrée sous une couche de diélectrique ;
La figure 3 illustre un second mode de réalisation du procédé selon l'invention avec formation d'une couche de piégeage de charges électriques enterrée sous une surface d'un substrat semi-conducteur ;
La figure 4 illustre une variante de réalisation au moyen de laquelle la région de piégeage de charges électriques prend la forme d'une structure multicouche qui présente l'intérêt d'une taille de grains réduit et de frontières de grains étendues pour la recombinaison des porteurs.

### DESCRIPTION DES MODES DE RÉALISATION

L'invention porte sur un procédé de fabrication d'un substrat RF-SOI de type semi-conducteur sur isolant pour applications radiofréquences. Ce procédé comprend une étape de collage d'un substrat support en matériau monocristallin et d'un substrat donneur comportant une couche mince d'un matériau semi-conducteur, une ou plusieurs couches de matériau diélectrique étant à l'interface.

Cette étape de collage est suivie d'une étape de report de ladite couche mince sur le substrat support. Ce report est réalisé selon une technique de transfert de couches minces basée sur un collage par adhésion moléculaire (également appelé collage direct). Parmi les techniques de transfert de couches minces, on peut notamment citer :
- le procédé Smart Cut™ selon lequel le report comprend une fracture du substrat donneur au niveau d'un plan de fragilisation issu d'une implantation ionique. Ce procédé est plus particulièrement basé sur une implantation d'ions légers d'hydrogène et/ou d'hélium dans le substrat donneur, un assemblage par collage direct (i.e. partout (sans ajout de matière adhésive à l'interface de collage) de ce substrat donneur avec le substrat support et un détachement d'une couche mince superficielle du substrat donneur par séparation au niveau du plan de fragilisation défini par la profondeur d'implantation des ions. Des étapes de finition, pouvant inclure des traitements thermiques à haute température, confèrent enfin la qualité cristalline et de surface requise à la couche transférée.
- les procédés de collage direct et d'amincissement mécanique, chimique et/ou mécano-chimique. Ces procédés consistent à assembler le substrat donneur par adhésion moléculaire avec le substrat support, puis à amincir le substrat donneur jusqu'à l'épaisseur souhaitée de couche active, par exemple par rectification (« grinding » selon la terminologie anglo-saxonne) et par polissage mécano-chimique (CMP pour « chemical mechanical polishing »).

Le substrat support est un substrat en un matériau monocristallin. Il peut être constitué de matériaux utilisés habituellement dans l'industrie de la micro-électronique, de l'optique, de l'optoélectronique, du photovoltaïque. Notamment, le substrat support peut comprendre au moins un matériau sélectionné parmi le silicium, le silicium-germanium et le carbure de silicium. Le substrat support est typiquement un substrat à haute résistivité, à savoir une résistivité typiquement supérieure à 1000 ohm.cm.

Le procédé comprend une étape de formation d'une région de piégeage de charges électriques dans le substrat support en contact avec une couche de matériau diélectrique présente à l'interface de collage, par transformation d'une zone enterrée du substrat support en un polycristal.

La région de piégeage de charges électriques comprend un matériau de type silicium polycristallin, dont la densité de défauts est favorable au piégeage de charges électriques libres aptes à se développer dans le substrat support.

La ou les couches de matériau diélectrique présentes à l'interface vont constituer la couche isolante enterrée du substrat RF-SOI, cette couche isolante enterrée venant isoler électriquement la couche mince du substrat support. Cette couche isolante comprend typiquement au moins l'un des matériaux parmi le dioxyde de silicium, le nitrure de silicium ou l'oxyde d'aluminium.

Le substrat RF-SOI comprend également sur la couche isolante enterrée la couche mince reportée depuis le substrat donneur. Cette couche mince correspond à la couche active du substrat RF-SOI dans et/ou sur laquelle des composants RF peuvent être élaborés. La couche mince peut comprendre au moins l'un des matériaux parmi le silicium, le carbure de silicium ou le silicium-germanium.

Dans le cadre de l'invention, la région de piégeage de charges électriques n'est pas formée au moyen d'un dépôt sur le substrat support mais par transformation d'une zone enterrée du substrat support en un polycristal. Une telle transformation présente l'avantage de laisser la surface du substrat support intacte, prête au collage.

La transformation cristalline peut notamment comprendre une amorphisation de la zone enterrée du substrat support suivie d'une recristallisation sous forme polycristalline de la zone enterrée.

L'amorphisation de la zone enterrée peut notamment être réalisée au moyen d'une implantation ionique à travers la surface avant du substrat support, par exemple une ou plusieurs implantations d'ions lourds choisis parmi les espèces suivantes : silicium, lithium, carbone, oxygène ou fluor ou une combinaison de ces espèces. Ces implantations peuvent être réalisées simultanément ou successivement, dans des conditions (notamment en termes de dose et d'énergie) identiques ou différentes. L'oxygène et le fluor sont avantageux car ils permettent, en plus d'amorphiser le matériau, de ralentir la recristallisation en phase solide ou SPER (« Solid Phase Epitaxial Regrowth ») qui pourrait conduire à une recristallisation sous forme monocristalline et d'aider à la nucléation des germes en vue d'une recristallisation polycristalline.

La recristallisation sous forme polycristalline de la zone enterrée peut quant à elle être réalisée, ou à tout le moins initiée, au moyen d'un recuit laser qui vient typiquement induire une cristallisation selon un régime de cristallisation dite explosive. Pour ce faire, la surface avant du substrat support est soumise à une irradiation laser, de préférence une irradiation impulsionnelle, typiquement une irradiation avec une durée inférieure à la microseconde, typiquement de 200 nanosecondes, qui vient initier la recristallisation de la zone enterrée amorphisée depuis sa face agencée côté surface avant du substrat support.

De manière optionnelle, ce recuit laser peut être suivi d'un traitement thermique complémentaire et/ou d'un ou plusieurs recuits lasers complémentaires venant promouvoir le développement de la microstructure polycristalline générée par le recuit laser initial. Le traitement thermique complémentaire peut typiquement aller de 15 minutes à 500°C jusqu'à 2s à 1100°C. Il peut s'agir d'un recuit de type recuit rapide (communément désigné par l'acronyme RTA, de l'anglais « Rapid Thermal Annealing ») ou d'un recuit flash, de l'anglais « flash annealing ». Les recuits lasers complémentaires (jusqu'à 100 recuits) sont quant à eux réalisés de manière à ne pas permettre la fusion du matériau.

La région de piégeage de charges électriques peut former une couche continue de piégeage de charges électriques s'étendant sur toute la plaque. Une amorphisation et une recristallisation pleine plaque sont pour cela réalisées.

La transformation cristalline en polycristal peut cependant n'être réalisée qu'en une ou plusieurs zones localisées du substrat support, une ou plusieurs autres zones n'étant pas soumises à une telle transformation. Pour cela, l'amorphisation peut n'être réalisée que localement par implantation localisée. Un masque présentant des ouvertures laissant traverser les espèces à implanter peut pour cela être utilisé, les zones amorphisées se situant alors aux droits des ouvertures du masque. En variante, l'amorphisation peut être réalisée pleine plaque et la recristallisation sous forme polycristalline être localisée. Le recuit laser de recristallisation peut pour cela être réalisé à travers un masque. Les régions rendues polycristallines sont alors obtenues au niveau de la zone irradiée par le laser au droit des ouvertures du masque. Les régions amorphes non irradiées par le laser peuvent rester amorphes ou être rendues monocristallines par un traitement adapté, par exemple par un recuit de recristallisation en phase solide dit de SPER.

La formation de la région de piégeage de charges électriques peut être réalisée avant ou après le transfert. En variante, on peut réaliser l'amorphisation avant le collage et la recristallisation en polycristal après le transfert.

On prend dans ce qui suit l'exemple de la formation d'une couche pleine plaque, étant rappelé que l'invention n'est pas limitée à cet exemple.

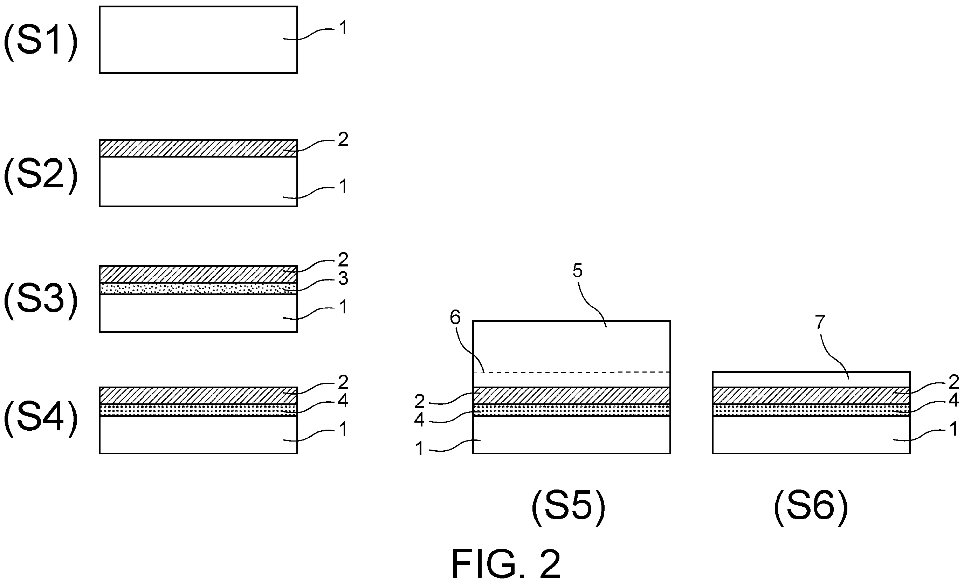

Dans un premier mode de réalisation de l'invention illustré sur la figure 2, la couche de piégeage de charges électriques 4 est formée par transformation polycristalline d'une couche du substrat support 1 enterrée sous une couche de diélectrique 2. Le procédé de fabrication débute par une étape (S1) de fourniture du substrat support en silicium monocristallin et se poursuit par une étape (S2) de formation d'une couche 2 de matériau diélectrique en surface du substrat support 1, par exemple selon une oxydation thermique du substrat support sur une épaisseur pouvant être comprise entre 5nm et 400nm. Cette oxydation est ainsi réalisée avant la formation de la couche de polysilicium et ne présente donc pas les inconvénients précités d'une oxydation d'une telle couche de polysilicium.

Le procédé se poursuit avec une étape (S3) d'amorphisation d'une portion supérieure du substrat support 1 à travers la couche 2 de matériau diélectrique. Cette amorphisation, au moyen d'une implantation ionique dont l'énergie est adaptée à l'épaisseur de la couche diélectrique 2, vient former une couche amorphe enterrée 3 directement sous la couche 2 de matériau diélectrique, c'est-à-dire sans couche intermédiaire entre la couche amorphe enterrée 3 et la couche 2 de matériau diélectrique. La couche amorphe enterrée 3 peut avoir une épaisseur comprise entre 5nm et 200 nm par exemple À titre d'exemples, une implantation d'ions silicium d'énergie 20 keV et de dose 2,5.10¹⁴ atomes/cm², respectivement d'énergie 40 keV et de dose 2,5.10¹⁴ atomes/cm² ou d'énergie 150 keV et de dose 4,25.10¹⁴ atomes/cm², dans un substrat de silicium monocristallin permet de former une couche amorphe de 30nm d'épaisseur enterrée 10nm sous la surface du substrat, respectivement une couche amorphe de 30nm d'épaisseur enterrée 30nm sous la surface du substrat ou une couche amorphe de 170nm d'épaisseur enterrée 75nm sous la surface du substrat.

Un traitement thermique du substrat support peut ensuite être réalisé afin d'y lisser l'interface amorphe/cristal et ainsi promouvoir la recristallisation subséquente de la couche amorphe enterrée. Ce traitement thermique de lissage est réalisé à une température suffisamment basse et pendant un temps suffisamment court pour éviter une recristallisation trop importante de la couche amorphe. Il peut être réalisé par exemple à 500°C pendant 1 à 5 min pour du silicium.

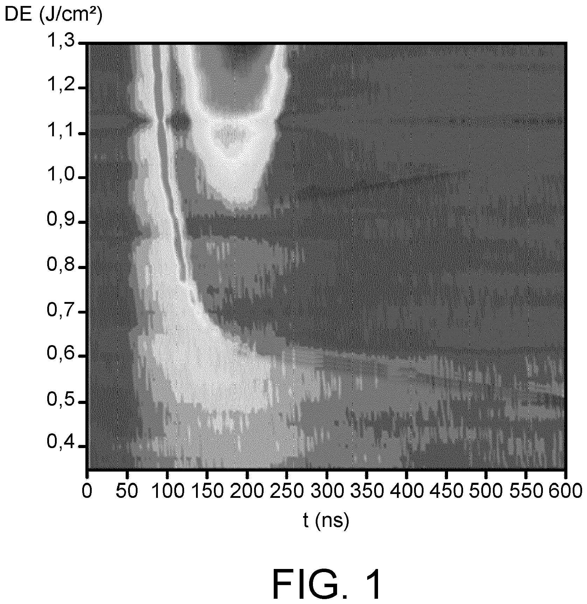

Un recuit laser est appliqué au cours d'une étape (S4) qui vient transformer (ou à tout le moins initier une telle transformation) la couche amorphe enterrée en une couche polycristalline enterrée 4. Ce recuit par laser peut être effectué à une longueur d'onde comprise entre 200 nm et 400 nm avec une durée d'impulsion relativement courte (inférieure à la microseconde et idéalement de l'ordre de quelques centaines de nanosecondes). Ce recuit laser vise à induire une cristallisation selon un régime de cristallisation dite explosive. Un tel régime peut notamment être détecté au moyen d'une observation de la réflectivité de surface. La figure 1 illustre à cet égard un exemple de réflectivité d'une couche de Si amorphe en fonction de la densité d'énergie DE (en J/cm²) du faisceau laser utilisé et de la durée t (en ns) de l'irradiation laser. L'initiation de la transformation du silicium amorphe y est repérée comme le premier changement important de réflectivité, comme par exemple celui repéré avec une impulsion laser de 150 ns présentant une densité d'énergie de 0,65 J/cm². Une telle détection peut être employée pour déterminer les conditions opératoires appropriées à la zone enterrée à recristalliser sous forme polycristalline.

Un traitement thermique complémentaire du substrat support ou des recuits lasers complémentaires peuvent ensuite être réalisés, comme précédemment expliqué, afin de promouvoir le développement de la microstructure polycristalline.

Le procédé peut également comprendre un retrait de tout ou partie de la couche diélectrique 2, par exemple par gravure sélective.

Le procédé se poursuit avec une étape (S5) de collage du substrat support avec un substrat donneur 5 présentant un plan de fragilisation 6 issue d'une implantation d'hélium et/ou d'hydrogène, la couche diélectrique 2 étant à l'interface dans cet exemple. Un recuit de séparation est ensuite appliqué lors d'une étape (S6) qui conduit à la fracture du substrat donneur au niveau du plan de fragilisation et au transfert d'une couche mince 7 du substrat donneur vers le substrat support. Un traitement de finition de surface peut ensuite être appliqué à la couche mince transférée 7.

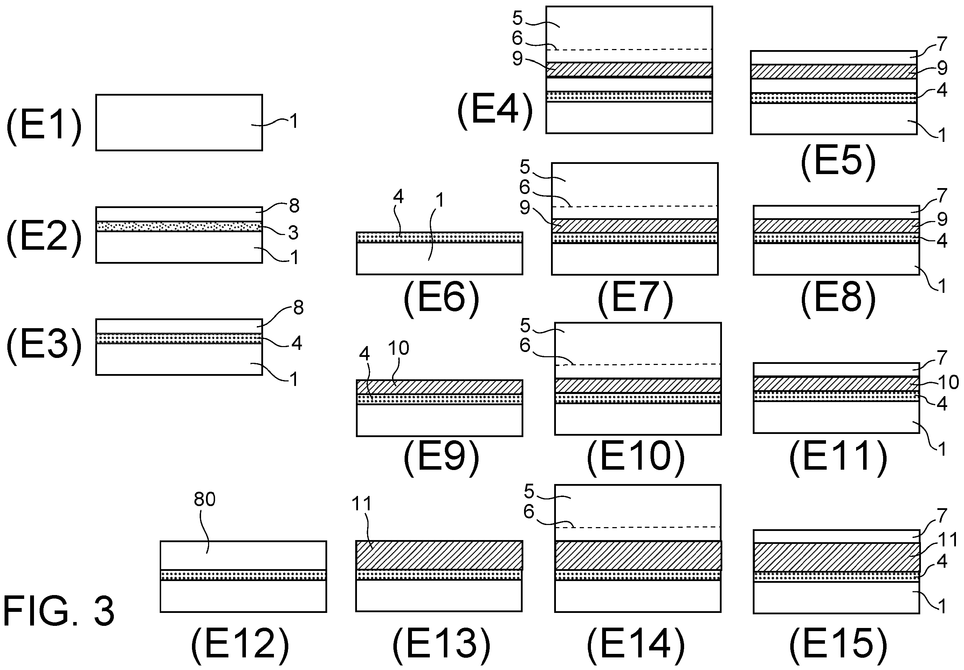

Dans un second mode de réalisation de l'invention illustré sur la figure 3, la couche de piégeage de charges électriques 4 est formée par transformation polycristalline d'une couche du substrat support 1 enterrée sous la surface du substrat. Le procédé de fabrication débute par une étape (E1) de fourniture du substrat support en silicium monocristallin et se poursuit par une étape (E2) d'amorphisation d'une couche enterrée du substrat support au moyen d'une implantation ionique telle que précédemment décrite. Cette amorphisation vient former une couche amorphe enterrée 3 qui sépare une partie massive du substrat support d'une couche superficielle monocristalline 8.

Un traitement thermique du substrat support peut optionnellement ensuite être réalisé afin d'y lisser les interfaces amorphe/cristal et ainsi promouvoir la recristallisation subséquente de la couche amorphe enterrée.

Un recuit laser est appliqué au cours d'une étape (E3) qui vient transformer (ou à tout le moins initier une telle transformation) la couche amorphe enterrée en une couche polycristalline enterrée 4. Un traitement thermique complémentaire et/ou des recuits lasers complémentaires peuvent optionnellement être ensuite réalisés, comme précédemment expliqué, afin de promouvoir le développement de la microstructure polycristalline.

Dans une première variante, le procédé se poursuit avec une étape (E4) de collage du substrat support avec un substrat donneur 5 présentant un plan de fragilisation 6 issue d'une implantation d'hélium et/ou d'hydrogène, le substrat donneur 5 étant recouvert d'une couche diélectrique 9, par exemple d'oxyde de silicium. Un recuit de séparation est ensuite appliqué lors d'une étape (E5) qui conduit à la fracture du substrat donneur au niveau du plan de fragilisation et au transfert d'une couche mince 7 du substrat donneur vers le substrat support. Un traitement de finition de surface peut ensuite être appliqué à la couche mince transférée 7.

Dans une seconde variante, le procédé se poursuit après l'étape (E3) avec une étape (E6) de retrait de la couche superficielle monocristalline 8, par exemple par oxydation suivie d'une gravure sélective de l'oxyde créé, puis avec des étapes de collage (E7) et de séparation (E8) similaires aux étapes (E4) et (E5).

Dans une troisième variante, le procédé se poursuit après l'étape (E3) avec une étape (E9) d'oxydation de tout ou partie de la couche superficielle monocristalline 8 pour former une couche d'oxyde 10 puis avec une étape (E10) de collage avec un substrat donneur 5 présentant un plan de fragilisation. Ce substrat donneur peut comporter ou non une couche superficielle pour favoriser le collage (par exemple une couche diélectrique qui peut être en oxyde de silicium). Un recuit de séparation est ensuite appliqué lors d'une étape (E11) qui conduit à la fracture du substrat donneur au niveau du plan de fragilisation et au transfert d'une couche mince 7 du substrat donneur vers le substrat support.

Dans une quatrième variante, le procédé se poursuit après l'étape (E3) par une étape (E12) d'épaississement du substrat support conduisant, par exemple au moyen d'une épitaxie, à une couche superficielle monocristalline épaissie 80. Le procédé se poursuit avec une étape (E11) d'oxydation de tout ou partie de la couche superficielle monocristalline épaissie pour former une couche d'oxyde 11 puis avec une étape (E10) de collage avec un substrat donneur 5 pouvant comporter ou non une couche superficielle pour favoriser le collage (par exemple une couche diélectrique qui peut être en oxyde de silicium) et présentant un plan de fragilisation 6 et une étape (E11) de fracture du substrat donneur au niveau du plan de fragilisation conduisant au transfert d'une couche mince 7 du substrat donneur vers le substrat support. Cette variante permet de répondre à des besoins d'oxyde épais de bonne qualité, avec par exemple une couche 11 d'épaisseur supérieure à 400nm.

Dans les différentes variantes, lorsque la couche superficielle monocristalline 8 éventuellement épaissie 80 est oxydée, l'oxydation conjuguée à un nettoyage permet de réduire l'épaisseur de la couche superficielle monocristalline 8 et/ou d'éliminer des contaminants de surface qui auraient été introduits par l'implantation ionique d'amorphisation.

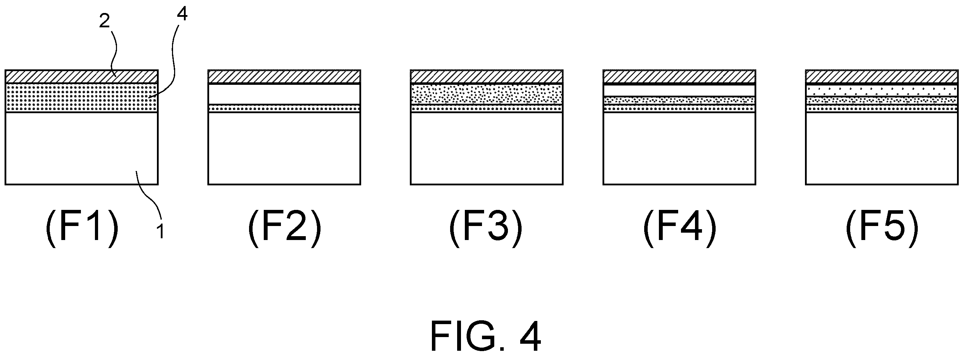

Dans un troisième mode de réalisation représenté sur la figure 4, la recristallisation sous forme polycristalline de la couche enterrée comprend une pluralité de recuits laser venant successivement recristalliser une épaisseur décroissante de la zone enterrée depuis l'interface avec la couche diélectrique 2. Partant lors d'une étape (F1) d'une structure comprenant une couche 4 enterrée recouverte d'une couche d'oxyde 2 et rendue polycristalline par un premier recuit laser, ce mode de réalisation comprend par exemple l'application (F2) d'un second recuit laser venant fondre la couche enterrée 4 sur une épaisseur d2 inférieure à l'épaisseur de la couche 4. Ce second recuit laser conduit (F3) à la formation d'une couche enterrée 4 sous la forme d'une structure polycristalline bi-couche. Un troisième recuit laser (F4) venant fondre la couche enterrée 4 sur une épaisseur d3 inférieure à d2 peut ensuite être réalisé qui conduit (F5) à une couche enterrée 4 sous la forme d'une structure polycristalline tri-couche. Un ou plusieurs traitements thermiques complémentaires peuvent être optionnellement réalisés après ces différents recuits laser ou entre un ou plusieurs, afin de promouvoir le développement de la microstructure polycristalline. Dans le même but, un ou plusieurs recuits lasers complémentaires ne permettant pas la fusion du matériau peuvent être réalisés.

Dans un quatrième mode de réalisation, l'amorphisation est réalisée pleine plaque, avant ou après le transfert de la couche mince 7 du substrat donneur vers le substrat support, et la recristallisation sous forme polycristalline de la couche enterrée 4 a lieu après ce transfert. Dans ce cas, la température lors du transfert (et notamment pendant le recuit de renforcement du collage et le recuit de séparation) est limitée à une température inférieure à 500°C. Il est alors possible d'effectuer le recuit laser de recristallisation à travers un masque afin de former des zones polycristallines localisées comme déjà évoqué. Les autres régions non irradiées par le laser peuvent quant à elles être rendues monocristallines par un traitement adapté, par exemple par un recuit de recristallisation en phase solide dit de SPER. En variante, il est possible de réaliser l'amorphisation localement avant ou après transfert et de réaliser la recristallisation sous forme polycristalline pleine plaque ou localement au niveau des zones localement amorphisées.

Dans une cinquième mode de réalisation, des pores sont créés dans la zone amorphe ou la zone enterrée du substrat destinée à être amorphisée. Ces pores peuvent être créés sur toute l'épaisseur de cette zone ou au moins sur une partie de cette zone, de préférence la partie la plus enterrée de la zone amorphe ou à amorphiser (au contact ou à proximité de la partie monocristalline du substrat). Il est possible de créer ces pores également dans la zone monocristalline du substrat située directement sous la zone amorphe ou la zone enterrée du substrat destinée à être amorphisée.

Ces pores peuvent être créés avant ou après la formation de la couche de piégeage polycristalline. Ils servent à stabiliser cette couche une fois celle-ci formée lors de traitement thermique ultérieur à haute température, par exemple à plus de 1000°C, pouvant intervenir notamment lors de la fabrication du substrat SOI ou des composants réalisés sur ce substrat, en limitant la croissance des grains formés et la transmission de la structure cristalline de la partie monocristalline du substrat à la couche de piégeage.

Lorsque ces pores sont créés avant la recristallisation, ils vont permettre par ailleurs de renforcer la recristallisation sous forme polycristalline lors de cette recristallisation en limitant également la propagation des fronts de recristallisation venant de la partie monocristalline du substrat.

Ces pores peuvent être sous forme de cavités et/ou de bulles. Ils peuvent être obtenus par implantation d'espèces gazeuses, telles que de l'hydrogène ou des gaz nobles, notamment de l'hélium ou du néon, seuls ou en combinaison, simultanément ou séquentiellement. Une telle implantation permet d'enrichir en gaz la zone enterrée pour former des pores. Un traitement thermique peut ensuite être réalisé afin de faire maturer ces pores et/ou permettre l'évacuation de tout ou partie des espèces gazeuses présentes dans ces pores. Les conditions d'implantation et de traitement thermique sont choisies de sorte qu'elles n'engendrent pas de délamination au niveau de la zone enterrée.

Pour plus de détails sur cette étape, on pourra se référer à l'article de V. Ranieri et al. Intitulé « Gettering of metals by voids in silicon », Journal of Applied Physics 78, 3727 (1995); https://doi.org/10.1063/1.359953 et à la demande FR19/15019 dont la présente demande revendique la priorité et dont le contenu fait partie intégrante de la présente description.

Ces pores peuvent être réalisés pleine plaque ou localement par implantation au travers un masque. S'ils sont localisés, ils sont avantageusement disposés dans des zones au droit de zones polycristallines localisées. Ils peuvent être créés avant ou après l'étape d'amorphisation, avant ou après la formation de la couche diélectrique 2 s'il y en a une.

La zone poreuse peut également être formée par voie électrochimique lors de la réalisation du substrat.

On obtient ainsi un substrat RF-SOI comportant en empilement dans cet ordre un socle en matériau semi-conducteur monocristallin, une couche de piégeage de charges électriques en matériau semiconducteur polycristallin, une couche diélectrique directement au contact de la couche de piégeage et une couche active. Avantageusement, le matériau semi-conducteur de la couche de piégeage est le même que celui du socle. Ce substrat RF-SOI comprend en outre une couche poreuse entre le socle et la couche de piégeage. Cette couche poreuse se compose d'un squelette solide et d'une distribution de pores vides et/ou remplis de gaz.

Une partie au moins du squelette de la couche poreuse peut être monocristallin. C'est le cas lorsque la couche poreuse est réalisée sous la couche amorphe ou à amorphiser ou lorsque l'amorphisation n'a lieu que sur une partie de la couche poreuse ou à porosifier.

Une partie au moins du squelette de la couche poreuse peut être polycristallin. C'est le cas lorsque l'amorphisation a lieu sur au moins une partie de la couche poreuse ou à porosifier. Il est possible que toute la couche de piégeage soit poreuse.

La couche de piégeage de charges électriques peut être localisée formant dans le plan du substrat des zones de piégeage polycritallines ou dont une une partie au moins du squellette est polycristallin lorsqu'elles sont au moins en partie poreuses.

Les zones contiguës à ces zones de piégeage dans le plan du substrat sont alors avantageusement monocristallines.

## Revendications

1. Procédé de fabrication d'un substrat de type semi-conducteur sur isolant pour
applications radiofréquences, comprenant les étapes de
collage direct d'un substrat support (1) en matériau monocristallin et d'un substrat donneur (5) comportant une couche mince (7) en matériau semi-conducteur, une ou plusieurs couches de matériau diélectrique (2, 9, 10, 11) étant à l'interface ; et de
report de ladite couche mince (7) sur le substrat support ;
**caractérisé en ce qu'**il comprend une étape de formation d'une région de piégeage de charges électriques (4) dans le substrat support (1) en contact avec une couche de matériau diélectrique présente à l'interface, par transformation d'une zone enterrée du substrat support en un polycristal.

2. Procédé selon la revendication 1, dans lequel ladite transformation comprend une amorphisation de la zone enterrée du substrat support suivie d'une recristallisation sous forme polycristalline de la zone enterrée.

3. Procédé selon la revendication 2, dans lequel l'amorphisation comprend une implantation ionique.

4. Procédé selon l'une des revendications 2 et 3, dans lequel la recristallisation sous forme polycristalline comprend au moins un recuit laser engendrant la création d'une microstructure polycristalline dans la zone enterrée.

5. Procédé selon la revendication 4, dans lequel la recristallisation sous forme polycristalline comprend une pluralité de recuits laser venant successivement recristalliser une épaisseur décroissante de la zone enterrée.

6. Procédé selon l'une des revendications 4 et 5, dans lequel la recristallisation sous forme polycristalline comprend après l'au moins un recuit laser une étape de traitement thermique complémentaire ou un recuit laser complémentaire venant promouvoir le développement de la microstructure polycristalline.

7. Procédé selon l'une des revendications 2 à 6 comprenant, avant l'amorphisation de la zone enterrée du substrat support, la formation d'une couche de matériau diélectrique (2) en surface du substrat support.

8. Procédé selon la revendication 7, dans lequel la formation d'une couche de matériau diélectrique (2) en surface du substrat support est réalisée par oxydation thermique.

9. Procédé selon l'une des revendications 7 et 8, dans lequel l'amorphisation de la zone enterrée du substrat support est réalisée dans la zone enterrée du substrat situé directement sous la couche de matériau diélectrique (2).

10. Procédé selon l'une des revendications 1 à 9, dans lequel le substrat donneur est recouvert d'une couche de matériau diélectrique (2, 9).

11. Procédé selon l'une des revendications 4 à 10, dans lequel l'amorphisation de la zone enterrée du substrat support est réalisée après report de ladite couche mince (7) sur le substrat support.

12. Procédé selon l'une des revendications 4 à 11, dans lequel l'au moins un recuit laser est réalisé à travers un masque afin de former une zone polycristalline localisée formant la région de piégeage de charges électriques (4).

13. Procédé selon la revendication 10 comprenant, après la réalisation de la région de piégeage de charges électriques et avant le collage du substrat support et du substrat donneur, une étape de retrait d'une couche superficielle du substrat support (8).

14. Procédé selon l'une des revendications 4 à 11, comprenant, après la réalisation de la région de piégeage de charges électriques et avant le collage du substrat support et du substrat donneur, une étape d'oxydation d'une couche superficielle du substrat support (8).

15. Procédé selon la revendication 13, dans lequel l'étape d'oxydation est précédée d'une étape d'épaississement du substrat support.

16. Procédé selon l'une des revendications 2 à 15, comprenant une étape de formation de pores dans la zone enterrée du substrat support ou une zone directement sous-jacente à ladite zone enterrée dans le substrat support.

17. Procédé selon la revendication 16, dans lequel l'étape de formation de pores dans la zone enterrée du substrat support est réalisée avant la recristallisation sous forme polycristalline de la zone enterrée.

18. Procédé selon l'une des revendications 16 et 17, dans lequel l'étape de formation de pores est réalisée de manière localisée.

19. Procédé selon l'une des revendications 1 à 18, dans lequel la zone enterrée du substrat support est une couche pleine plaque.

20. Substrat de type semi-conducteur sur isolant pour applications radiofréquences, comprenant l'empilement d'un socle en matériau semi-conducteur monocristallin, d'une couche de piégeage de charges électriques (4) en matériau semiconducteur polycristallin, d'une couche diélectrique directement au contact de la couche de piégeage de charges électriques et d'une couche mince (7) en matériau semi-conducteur, **caractérisé en ce que** l'empilement comprend en outre une couche poreuse entre le socle et la couche de piégeage de charges électriques.
